# EUROPEAN PATENT APPLICATION

(11) **EP 4 653 834 A1**
(43) Date of publication of application: **26.11.2025**
(21) Application number: 23917614.2
(22) Date of filing: 25.10.2023
(51) Int. Cl.: G01L 9/00, B81B 3/00, B81C 1/00, H01L 29/84

(54) **PRESSURE SENSOR MODULE AND METHOD FOR PRODUCING PRESSURE SENSOR MODULE**

(30) Priority: 17.01.2023 JP 2023004931
(71) Applicant: HITACHI HIGH-TECH CORPORATION, Tokyo 105-6409 (JP)
(72) Inventor: KANAMARU Masatoshi, Tokyo 100-8280 (JP); AONO Takanori, Tokyo 100-8280 (JP); IKEDA Hiroshi, Tokyo 100-8280 (JP); TANOUE Hidetsugu, Tokyo 105-6409 (JP); SUZUKI Yoichiro, Tokyo 105-6409 (JP)
(74) Representative: Mewburn Ellis LLP
(86) International application number: PCT/JP2023/038433
(87) International publication number: WO 2024/154402

(57) **Abstract**

Provided is a small and highly accurate pressure sensor module that can be disposed in the vicinity of a nozzle of a dispensing apparatus and can measure a minute pressure change during aspiration and discharge. The pressure sensor module includes a flow path substrate including therein a flow path and a branch path branched from the flow path, a semiconductor chip including a piezoresistive element and covering an opening of the branch path, and a cap bonded onto the semiconductor chip to cover the piezoresistive element and forming a cavity between the cap and the semiconductor chip. A ventilation path that allows the cavity to communicate with outside is formed in the cap or a bonding portion between the cap and the semiconductor chip, and a shape of the opening of the branch path and a shape of the cavity are substantially similar in a normal direction.

## Description

### Technical Field

The present invention relates to a structure of a pressure sensor module and a method for producing the same, and more particularly to a technique effectively applied to a pressure sensor module using a piezoresistive semiconductor element.

### Background Art

A general pressure sensor is implemented by forming or bonding a piezoresistive element or the like on a diaphragm made of a silicon material or a non-conductive material such as ceramic. The diaphragm is deformed by an external pressure of a liquid or a gas, and an amount of change in the diaphragm is electrically measured as a change in resistance by a Wheatstone bridge circuit or the like and is converted into a pressure value to measure the pressure.

For example, in a production method for forming a diaphragm on a semiconductor substrate, a part of a surface of the semiconductor substrate opposite to a surface where a detection element is formed is thinned by a silicon anisotropic etching method or a grinding processing method to form the diaphragm. A certain measurement area can be formed by etching or grinding a part of the semiconductor substrate. In addition, a sensing portion of the semiconductor substrate where a piezoresistive element and the like are formed is thinned to any thickness by etching or grinding, and the diaphragm can be easily deformed when a pressure is applied.

As a background art of this technical field, for example, there is a technique as disclosed in PTL 1. PTL 1 discloses "a semiconductor pressure sensor production method of thinning, by etching or polishing, a substrate where a strain-sensitive element is formed".

PTL 2 discloses "an electronic component excellent in mechanical strength and weather resistance and a method for producing the same".

### Citation List

### Patent Literature

PTL 1: JP2001-332746A
PTL 2: JP2012-186761A

### Summary of Invention

### Technical Problem

In a dispensing apparatus that aspirates and discharges a liquid serving as a specimen or a sample, a small and highly accurate pressure sensor module that can be disposed in the vicinity of a nozzle is required in order to grasp a minute pressure change during aspiration and discharge by the nozzle and to perform highly accurate detection of dispensing abnormalities and dispensing amount estimation.

However, the techniques in PTL 1 and PTL 2 have the following problems, and there is room for improvement in application to a dispensing apparatus.

In the structure of the semiconductor pressure sensor in PTL 1, it is possible to improve sensitivity of the strain-sensitive element when a pressure is applied by thinning, using a method of etching or polishing, a silicon wafer where the strain-sensitive element is formed.

However, since the structure is a three-layer stacked structure of a cap substrate, the silicon wafer where the strain-sensitive element is formed, and a pedestal substrate, two bonding portions are required, which increases bonding processes and complicates the structure.

There is a cavity space inside a cap, a trench is formed in a part of a surface of the cap to be bonded to the silicon wafer, and the cavity space and a peripheral portion are allowed to communicate with each other by dicing. However, it is expected that misalignment also doubles due to bonding at two sites, and there is a concern that a chip dimension is required to be increased in consideration of the misalignment in order to perform dicing at a position of a ventilation path trench.

A thickness of the three-layer stacked structure is not disclosed, and a method for forming the cavity and the ventilation path formed in the cap substrate is simply disclosed as etching, and there is no description of a specific formation process.

Further, there is no description about how to electrically extract a signal from the silicon wafer where the strain-sensitive element is formed, and there is no description about a method for attaching the semiconductor pressure sensor for measuring a pressure.

In the structure in PTL 2, since a trench of a cap substrate is formed by dicing with half cut, it can be predicted that a variation in a trench depth increases, and when bonding to a wafer, it is considered that a resin material is to be held at an intermediate height, that is, in the case of a low load, a bonding failure portion occurs, and in the case of a high load, the resin material is penetrated and a wafer front surface where a plurality of electrode patterns are formed is reached, and thus it can be predicted that load control is difficult.

Since a space of a bonding hollow portion has a small height and is sealed, in a pressure fluctuation accompanied by deformation of the substrate, a pressure in the hollow portion increases to interfere with the deformation of the substrate and thus it can be predicted that the structure cannot be applied to a pressure sensor.

In a method for forming electrical wiring, a metal film is formed at a front surface with irregularities, and the wiring is formed by photolithography. Therefore, when forming wiring at a front surface with significant irregularities, it is required to form a thick metal film in order to prevent disconnection at a corner portion, and it can be predicted that there is a problem in productivity.

Therefore, an object of the invention is to provide a small and highly accurate pressure sensor module that can be disposed in the vicinity of a nozzle of a dispensing apparatus and can measure a minute pressure change during aspiration and discharge, and a method for producing the same.

### Solution to Problem

In order to solve the above problems, the invention includes: a flow path substrate including therein a flow path and a branch path branched from the flow path; a semiconductor chip including a piezoresistive element and covering an opening of the branch path; and a cap bonded onto the semiconductor chip to cover the piezoresistive element and forming a cavity between the cap and the semiconductor chip, in which a ventilation path that allows the cavity to communicate with outside is formed in the cap or a bonding portion between the cap and the semiconductor chip, and a shape of the opening of the branch path and a shape of the cavity are substantially similar in a normal direction.

The invention also provides a pressure sensor module production method for producing a pressure sensor module having the above features, the method including: (a) a step of preparing a first substrate where a plurality of piezoresistive elements are formed; (b) a step of forming a plurality of trenches having different depths in a second substrate by dry etching using a multilayer mask method; (c) a step of forming a resin material on a front surface of the first substrate and patterning; (d) a step of positioning using an alignment mark of the first substrate and an alignment mark of the second substrate, and bonding the first substrate and the second substrate by heating and pressurization; and (e) a step of thinning the first substrate and the second substrate by grinding surfaces of the first substrate and the second substrate, which are integrated in the step (d), opposite to bonding surfaces of the first substrate and the second substrate, and a step of dicing the first substrate to singulate the first substrate and the second substrate which are integrated.

### Advantageous Effects of Invention

According to the invention, it is possible to implement a small and highly accurate pressure sensor module that can be disposed in the vicinity of a nozzle of a dispensing apparatus and can measure a minute pressure change during aspiration and discharge, and a method for producing the same.

Accordingly, this can contribute to improvement in accuracy and reliability of the dispensing apparatus.

Problems, configurations, and effects other than those described above will be clarified by the following description of embodiments.

### Brief Description of Drawings

[FIG. 1A] FIG. 1A is a perspective view showing a structure of a pressure sensor module according to a first embodiment.
[FIG. 1B] FIG. 1B is a cross-sectional view showing the structure of the pressure sensor module according to the first embodiment.
[FIG. 2A] FIG. 2A is a perspective view showing a detailed structure of a pressure sensor according to the first embodiment.
[FIG. 2B] FIG. 2B is a cross-sectional view taken along line A-A in FIG. 2A.
[FIG. 3] FIG. 3 is a diagram schematically showing a state of the pressure sensor when a pressure is applied.
[FIG. 4A] FIG. 4A is a diagram showing a planar shape of a branch path 20.
[FIG. 4B] FIG. 4B is a diagram showing a modification of FIG. 4A.
[FIG. 5A] FIG. 5A is a diagram showing a positional relationship among the branch path 20, a flow path substrate 25, and a cavity space 37.
[FIG. 5B] FIG. 5B is a diagram showing the positional relationship among the branch path 20, the flow path substrate 25, and the cavity space 37.
[FIG. 5C] FIG. 5C is a diagram showing the positional relationship among the branch path 20, the flow path substrate 25, and the cavity space 37.
[FIG. 6] FIG. 6 is a diagram showing a basic configuration of a dispensing apparatus according to the first embodiment.
[FIG. 7] FIG. 7 is a diagram showing an internal state of a pipe 8 in a dispensing arm 16 immediately after liquid aspiration.
[FIG. 8] FIG. 8 is a diagram showing a process flow for producing a cap substrate 24a for forming a cap 24.
[FIG. 9A] FIG. 9A is a diagram showing a part of a production process by wafer level packaging.
[FIG. 9B] FIG. 9B is a diagram showing a part of the production process by wafer level packaging.
[FIG. 10] FIG. 10 is a diagram showing a process flow for producing a pressure sensor by wafer level packaging.
[FIG. 11] FIG. 11 is a diagram showing a process flow for producing a pressure sensor by wafer level packaging according to a second embodiment.
[FIG. 12A] FIG. 12A is a perspective view showing a detailed structure of a pressure sensor according to a third embodiment.
[FIG. 12B] FIG. 12B is a cross-sectional view taken along line B-B in FIG. 12A.
[FIG. 13] FIG. 13 is a diagram showing a process flow for producing a cap substrate 24b for forming the cap 24.
[FIG. 14] FIG. 14 is a diagram showing a process flow for producing a pressure sensor by wafer level packaging.
[FIG. 15] FIG. 15 is a diagram showing a process flow for producing a pressure sensor by wafer level packaging according to a fourth embodiment.
[FIG. 16] FIG. 16 is a perspective view showing an implementation example of the pressure sensor module according to the first embodiment.
[FIG. 17] FIG. 17 is a cross-sectional view showing a structure of a pressure sensor module according to a fifth embodiment.

### Description of Embodiments

Hereinafter, embodiments of the invention will be described with reference to the drawings. In the drawings, the same components are denoted by the same reference signs, and detailed descriptions of redundant parts are omitted.

### First Embodiment

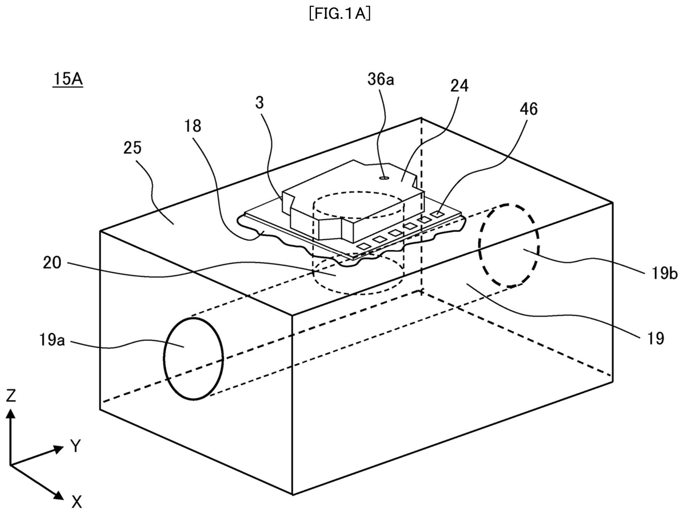

A pressure sensor module according to a first embodiment of the invention and a method for producing the same will be described with reference to FIGS. 1A to 10 and 16.

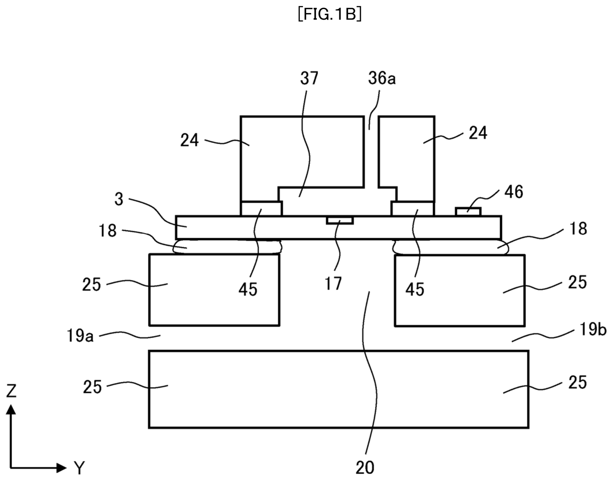

First, a schematic configuration of the pressure sensor module of the embodiment will be described with reference to FIGS. 1A and 1B. FIGS. 1A and 1B are diagrams showing a structure of a pressure sensor module 15A of the embodiment, and show a perspective view and a cross-sectional view, respectively.

A long-side direction, a short-side direction, and a height direction of the pressure sensor module 15A are shown as a Y-direction, an X-direction, and a Z-direction, respectively.

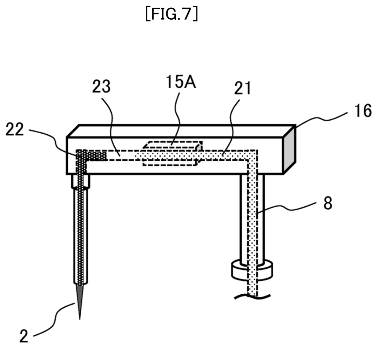

A flow path 19 is formed inside a flow path substrate 25, and screw portions (not shown) are provided at a flow path inlet 19a and a flow path outlet 19b. The flow path 19 can be connected to a pipe 8 of a dispensing apparatus 1 to be described later with reference to FIG. 7 via a joint. In addition, a branch path 20 branched toward the outside (Z-direction) of the flow path substrate 25 is provided inside the flow path 19, and a thin piezoresistive semiconductor chip 3 closes a terminal end of the branch path 20.

Specifically, the piezoresistive semiconductor chip 3 is bonded (adhered) to the flow path substrate 25 via an adhesive layer 18. As a material of the flow path substrate 25, stainless steel may be applied from the viewpoint of excellent corrosion resistance. In addition, a metal such as aluminum or titanium may be applied as long as the metal has high corrosion resistance. Further, a resin material such as acrylic may be applied. As a material of the adhesive layer 18, a silver paste, a silicone-based adhesive, an epoxy-based adhesive, thermal diffusion bonding, a thermosetting adhesive, a UV-curable adhesive, low-melting-point glass, or the like can be applied.

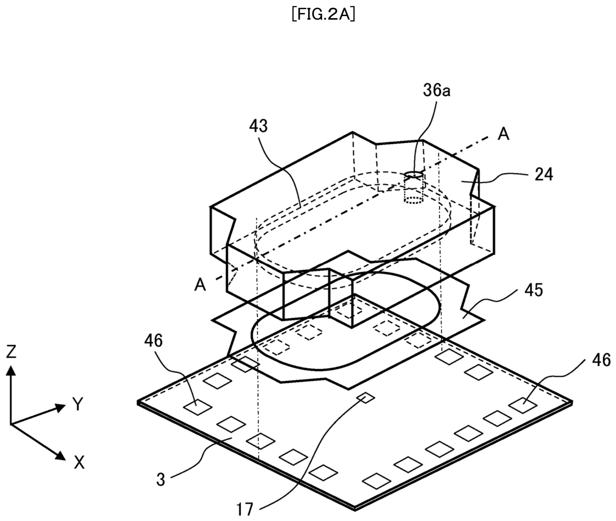

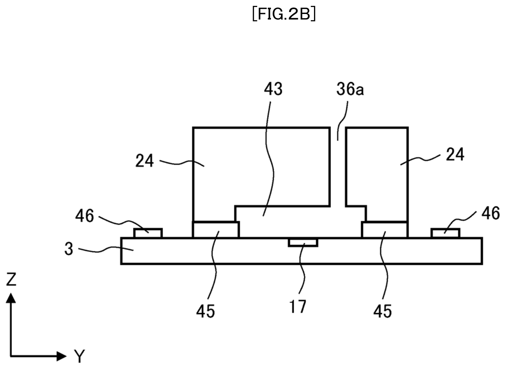

FIGS. 2A and 2B show a detailed structure of a pressure sensor of the embodiment. FIG. 2A is a perspective view showing the detailed structure of the pressure sensor of the embodiment, and FIG. 2B is a cross-sectional view taken along line A-A in FIG. 2A.

A long-side direction, a short-side direction, and a height direction of the pressure sensor are shown as the Y-direction, the X-direction, and the Z-direction, respectively.

In the piezoresistive semiconductor chip 3, a piezoresistive element 17 is formed at a central portion, a plurality of electrodes 46 are formed at an outer peripheral portion of the chip, and a cap 24 is disposed above. A cavity space 43 and a ventilation path 36a are formed in the cap 24, and the cap 24 is bonded to the piezoresistive semiconductor chip 3 by a bonding layer 45. Any pattern can be formed using a photosensitive resin material that can be patterned as a material of the bonding layer 45. Each electrode 46 electrically connected to the piezoresistive element 17 may be disposed on one side of the piezoresistive semiconductor chip 3 or may be disposed around the piezoresistive semiconductor chip 3.

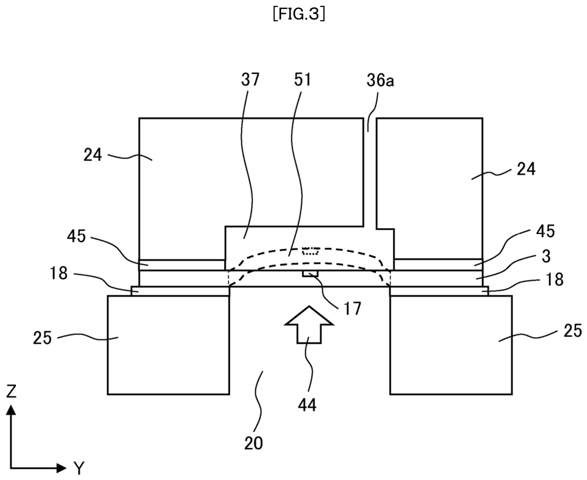

A positional relationship between a planar shape of the branch path 20 and a planar shape of the cavity space 37 will be described with reference to FIGS. 3 to 5C.

FIG. 3 is a diagram schematically showing a state of the pressure sensor when a pressure is applied, and shows a portion above the branch path 20 of the flow path substrate 25.

Inside the cap 24, the cavity space 37 and the ventilation path 36a that connects the cavity space 37 to the outside are formed. For example, when a water pressure 44 is applied to the branch path 20, the central portion of the piezoresistive semiconductor chip 3 undergoes flexural deformation upward (in the Z-direction) as indicated by a dotted line (deformation region 51). The ventilation path 36a is formed in a normal direction in the cavity space 37 of the cap 24.

Specifically, since a periphery of the piezoresistive semiconductor chip 3 is fixed to the flow path substrate 25 by the adhesive layer 18, only the central portion that is not fixed is displaced. The cavity space 37 formed in the cap 24 is a space for preventing interference with deformation of the piezoresistive semiconductor chip 3, and is formed as a trench larger in the Z-direction than an amount of displacement of the piezoresistive semiconductor chip 3. In addition, in order to reduce an influence of an increase in an internal pressure due to compression of the cavity space 37, the ventilation path 36a communicating with the outside is formed. Due to such flexural deformation, the piezoresistive element 17 senses strain and converts the strain into a resistance value change to measure the pressure.

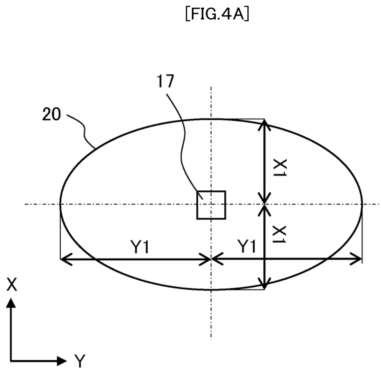

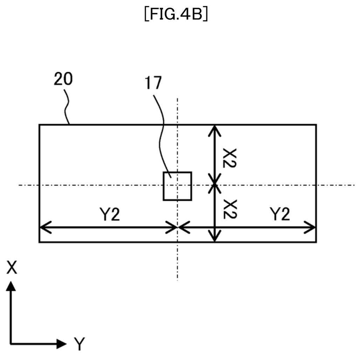

FIG. 4A is a diagram showing the planar shape of the branch path 20. FIG. 4B is a diagram showing a modification of FIG. 4A.

As described above, when the water pressure 44 is applied to the branch path 20, the piezoresistive semiconductor chip 3 undergoes flexural deformation. Therefore, as shown in FIG. 4A, the planar shape of the branch path 20 is preferably an elliptical shape.

As shown in FIG. 4B, the planar shape of the branch path 20 may also be a rectangular shape. In this rectangular shape, there is a concern that stress is likely to concentrate at four corner portions of the rectangular shape when the piezoresistive semiconductor chip 3 undergoes flexural deformation, and thus the planar shape of the branch path 20 is preferably formed by a curved line without corner portions. For example, it is effective to provide an R portion at the corner portions of the rectangular shape.

Meanwhile, in the invention, since a pressure value is converted from a displacement difference between the X-direction and the Y-direction, it is difficult to apply a perfect circle or square.

Further, when bonding the piezoresistive semiconductor chip 3 and the flow path substrate 25, it is preferable to align positions with high accuracy. The piezoresistive element 17 of the piezoresistive semiconductor chip 3 is preferably disposed at a central portion of the branch path 20, and a horizontal length Y1 and a vertical length X1 are preferably the same length.

In the piezoresistive element 17, since the piezoresistive semiconductor element 3 undergoes flexural deformation due to a pressure change and a resistance value change is measured based on a strain difference between the X-direction and the Y-direction, as shown in FIG. 4A, a length in the X-direction is preferably shorter than a length in the Y-direction such that Y1 + Y1 > X1 + X1. Even in the case of the rectangular planar shape, as shown in FIG. 4B, the length in the X-direction is preferably shorter than the length in the Y-direction such that Y2 + Y2 > X2 + X2.

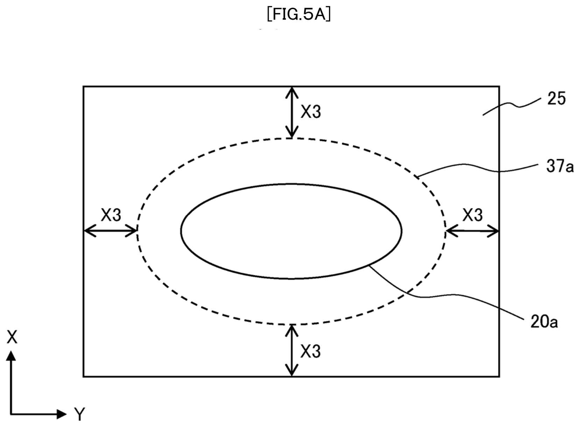

Next, a positional relationship among the branch path 20, the flow path substrate 25, and the cavity space 37 will be described with reference to FIGS. 5A to 5C.

A size of a branch path 20a in a planar direction shown in FIGS. 5A to 5C and a distance X3 (bonding width) from ends of the flow path substrate 25 to each of cavity spaces 37a, 37b, and 37c are the same.

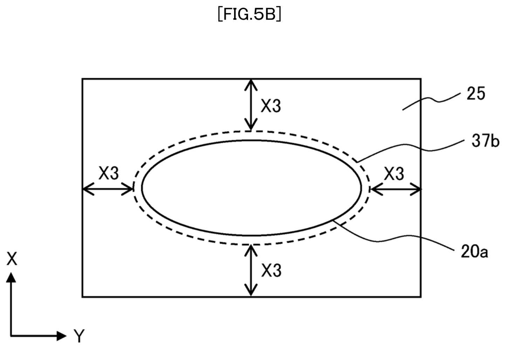

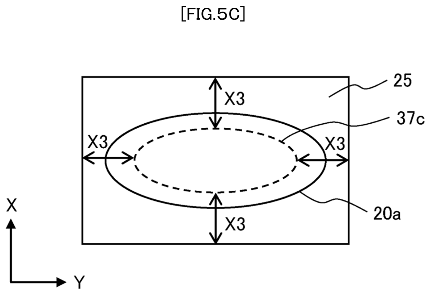

FIG. 5A shows a case where the cavity space 37a is larger than a shape of the branch path 20a, FIG. 5B shows a case where the cavity space 37b has substantially the same shape as the shape of the branch path 20a, and FIG. 5C shows a case where the cavity space 37c is smaller than the shape of the branch path 20a.

In the structure in FIG. 5A, the cavity space 37a can be formed to be large, and the flexural deformation of the piezoresistive semiconductor chip 3 is not interfered with, but an entire dimension of the flow path substrate 25 becomes large, and miniaturization becomes difficult. On the other hand, in the structure in FIG. 5C, the entire dimension of the flow path substrate 25 is reduced, which is effective for miniaturization, but a function as the pressure sensor deteriorates since the flexural deformation of the piezoresistive semiconductor chip 3 is interfered with. Therefore, in the invention, as in the structure in FIG. 5B, by making the shape of the cavity space 37b substantially the same as the shape of the branch path 20a, the entire dimension of the flow path substrate 25 can be small, and the flexural deformation of the piezoresistive semiconductor chip 3 is not interfered with.

In other words, in a normal direction of the cavity space 37b or in a plan view of the pressure sensor module 15A, a shape of an opening of the branch path 20a and the shape of the cavity space 37b are substantially similar to each other, and thus a small and highly accurate pressure sensor module can be obtained.

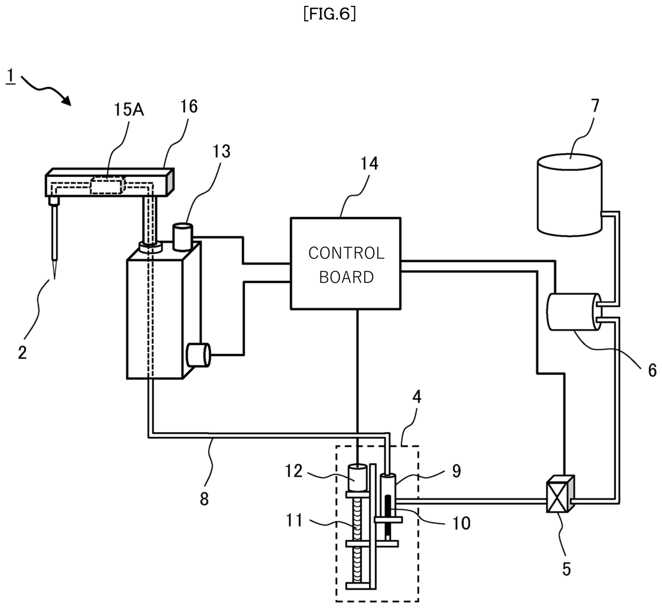

FIG. 6 is a diagram showing a basic configuration of the dispensing apparatus 1 equipped with the pressure sensor module 15A of the invention.

A flow path system of the dispensing apparatus 1 in the embodiment includes a nozzle 2, a syringe pump 4, an electromagnetic valve 5, a gear pump 6, and a tank 7 for storing system water, and the components are connected by the pipe 8. The syringe pump 4 includes a container 9, a plunger 10, a ball screw 11, and a drive motor 12. The drive motor 12 is controlled by a control board 14 in the same manner as a motor that drives a sample dispensing mechanism 13 and the like. The pressure sensor module 15A of the invention is provided in a dispensing arm 16. The dispensing arm 16 can rotate and move up and down in order to move to a position where a liquid that is a specimen or a sample is to be aspirated or discharged.

FIG. 7 is a diagram showing an internal state of the pipe 8 in the dispensing arm 16 immediately after liquid aspiration.

The pipe 8 is filled with system water 21, which is water for transmitting a syringe pressure, and a liquid 22 can be aspirated and discharged from the nozzle 2 by transmitting the pressure by the syringe pump 4. The system water 21 is supplied from the tank 7.

When the liquid 22 is aspirated from the nozzle 2, the plunger 10 in the syringe pump 4 is pulled while the electromagnetic valve 5 is in a closed state. On the other hand, when the liquid 22 is discharged from the nozzle 2, the plunger 10 in the syringe pump 4 is pushed into the container 9 while the electromagnetic valve 5 is in a closed state.

When aspirating the liquid 22 that is a specimen or a sample, the liquid 22 is aspirated after aspirating, by the nozzle 2, segmenting air 23 for segmenting such that the liquid 22 is not mixed with the system water 21 in the pipe 8. After the liquid 22 is discharged, the nozzle 2 is washed. During the washing of the nozzle 2, the system water 21 in the pipe 8 is pushed out simultaneously with application of washing water to an outer wall of the nozzle 2. In order to push out the system water 21 in the nozzle 2 during the washing, the electromagnetic valve 5 is opened and a pressure of the gear pump 6 is used, and thus the system water 21 can be delivered at a higher pressure compared to when pushing with the syringe pump 4.

The pressure sensor module 15A is provided at a part of the pipe 8 in the dispensing arm 16 in order to detect an abnormality such as clogging or air aspiration of the nozzle 2 which may occur during dispensing. The pressure sensor module 15A monitors a pressure of the system water 21 and detects a pressure change that occurs when an abnormality such as clogging or air aspiration of the nozzle 2 occurs.

As shown in FIG. 7, in the embodiment, in order to sensitively capture the pressure change in the nozzle 2, the pressure sensor module 15A is installed in the dispensing arm 16 as close as possible to the nozzle 2, but an installation position of the pressure sensor module 15A is not limited to the inside of the dispensing arm 16. For example, the pressure sensor module 15A may be installed on a side surface of the sample dispensing mechanism 13.

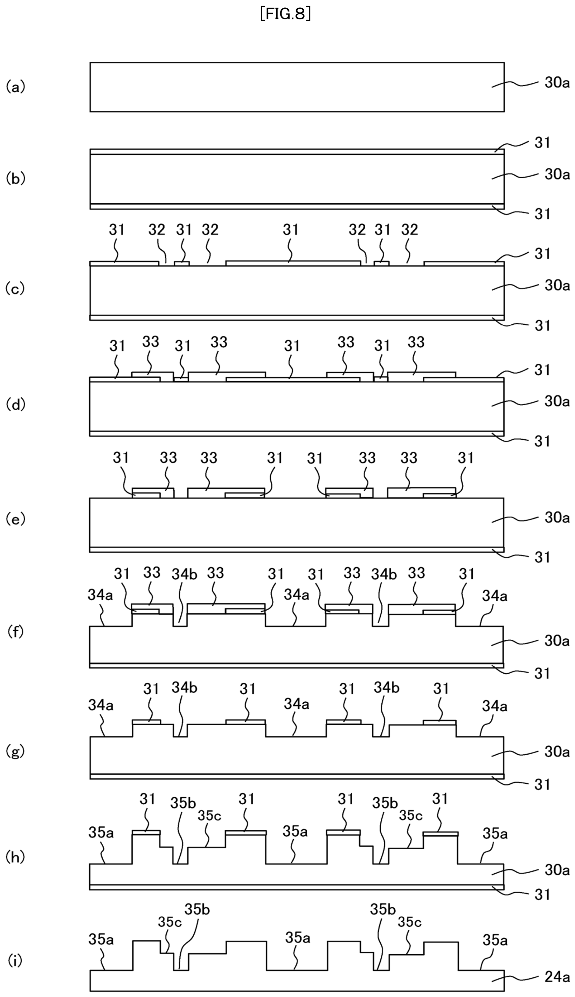

Next, a method for producing the pressure sensor by wafer level packaging including formation of the ventilation path will be described with reference to FIGS. 8 to 10.

FIG. 8 is a diagram showing a process flow for producing a cap substrate 24a for forming the cap 24. FIG. 8 is cross-sectional views showing steps from step (a) to step (i).

First, as shown in step (a), a silicon wafer 30a is prepared.

Next, in step (b), thermal oxide films 31 are formed on front and back surfaces of the silicon wafer 30a. The thermal oxide films 31 can be formed at a large number of silicon wafers by supplying wet oxygen gas at a high temperature, and thus have excellent productivity, but alternatively, oxide films may be formed using, for example, a sputtering apparatus. Before forming the thermal oxide films 31, an alignment mark may be formed on the back surface side of the silicon wafer 30a by photolithography and dry etching.

Next, in step (c), resist pattern formation (resist coating, exposure, and development) by photolithography, etching of the thermal oxide films 31, and resist removal are performed on the front surface of the silicon wafer 30a to form openings 32 in the thermal oxide film 31.

Next, in step (d), a resist pattern 33 is formed by photolithography to fill the openings 32 and partially overlap the thermal oxide film 31.

Thereafter, in step (e), the thermal oxide film 31 is patterned by etching using the resist pattern 33 as a mask. Accordingly, a multilayer mask is completed.

Next, in step (f), silicon dry etching is applied to form first etching trenches 34a and 34b. By applying the silicon dry etching, it is possible to form a trench having not only a linear planar shape but also a curved planar shape.

The etching trenches 34a and 34b are processed to have the same depth, for example, about 270 µm. The etching trench 34b is an etching trench for forming the ventilation path 36a.

Next, in step (g), the resist pattern 33 is removed. By removing the resist pattern 33, a new silicon front surface is exposed.

Next, in step (h), silicon dry etching is performed using the thermal oxide film 31 as a mask material. Accordingly, second etching trenches 35a and 35b and an etching trench 35c having a depth different from that of the etching trenches 35a and 35b are formed in the silicon wafer 30a, and multi-level trenches having different depths can be formed.

Finally, in step (i), the thermal oxide films 31 are removed to complete the cap substrate 24a having different steps (etching trenches 35a, 35b, and 35c). The cap substrate 24a can be formed of a 6-inch or 8-inch silicon wafer 30a.

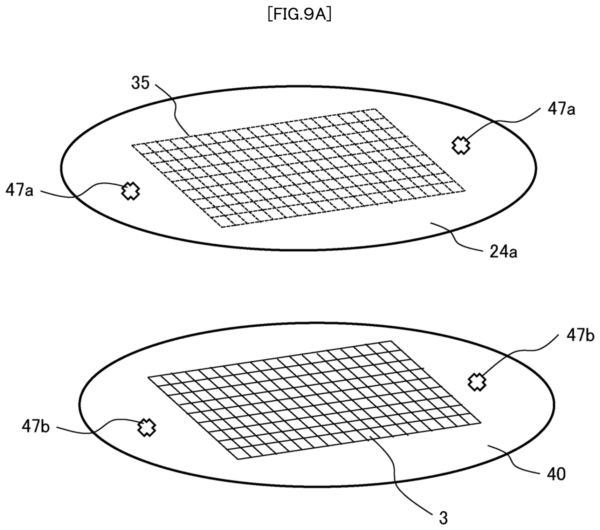

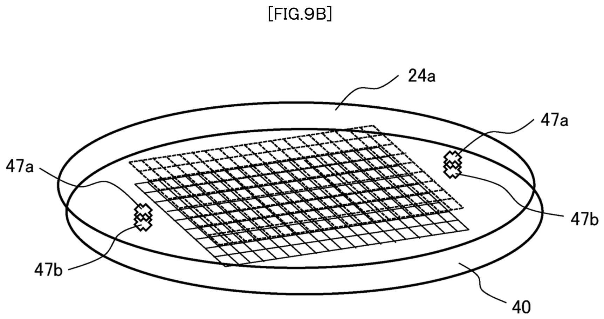

FIGS. 9A and 9B show a part of a production process by wafer level packaging.

In the method for producing by wafer level packaging, as shown in FIG. 9A, a surface of the cap substrate 24a having multi-level steps 35 is disposed on a lower side, a surface of another piezoresistive semiconductor wafer 40 where the piezoresistive semiconductor chip 3 is formed is disposed on an upper side, and after positioning with high accuracy by alignment marks 47a and 47b, stacking is performed as shown in FIG. 9B.

The alignment mark 47a of the cap substrate 24a may be formed on the same surface as the surface where the multi-level steps 35 are located, or may be formed on an opposite surface.

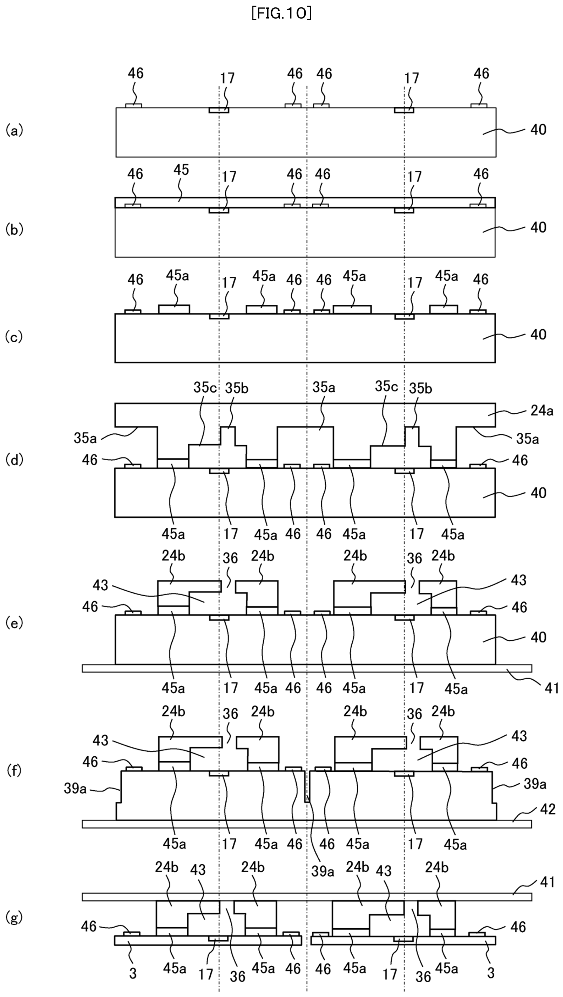

A detailed production method for the pressure sensor will be described with reference to FIG. 10. FIG. 10 is a diagram showing a process flow for producing the pressure sensor by wafer level packaging. FIG. 10 is cross-sectional views showing steps from step (a) to step (g).

First, as shown in step (a), the piezoresistive semiconductor wafer 40 is prepared. A plurality of piezoresistive elements 17 and a plurality of electrodes 46 are formed at the piezoresistive semiconductor wafer 40.

Next, in step (b), a resin material to be the bonding layer 45 is formed on a surface where the piezoresistive elements 17 and the electrodes 46 are formed. As the resin material 45, a photosensitive resin material is preferably used, and for example, a photosensitive film resist can be applied. If a photosensitive resin material is used, the resin can be planarized and patterned by spin coating.

Next, in step (c), a desired resin material pattern 45a is formed on the piezoresistive semiconductor wafer 40 by photolithography. Since the resin material has no conductivity, the cap substrate 24a can be insulated from the piezoresistive semiconductor wafer 40.

Thereafter, in step (d), the cap substrate 24a is aligned with high accuracy and stacked on the piezoresistive semiconductor wafer 40 by the method shown in FIGS. 9A and 9B. The steps 35 (etching trenches 35a, 35b, and 35c) of the cap substrate 24a correspond to the etching trenches 35a, 35b, and 35c in FIG. 8.

By applying pressure and temperature during bonding, the piezoresistive semiconductor wafer 40 and the cap substrate 24a are brought into close contact with each other using the resin material pattern 45a as the bonding layer. Bonding conditions are an applied pressure of 1 MPa and an applied temperature of 300 °C. At this time, the resin material shrinks due to the application of pressure and temperature. Therefore, the resin material before bonding is formed with a thickness in consideration of the shrinkage such that a thickness of the bonding layer after bonding is 50 µm or less, particularly about 20 µm.

Next, in step (e), a back-grinding tape 41 is attached to a lower surface side of the piezoresistive semiconductor wafer 40, and an upper surface side of the cap substrate 24a is ground. In the grinding, first, rough grinding is implemented by applying a grinding wheel of #2000, and then grinding is performed by applying a fine grinding wheel with a grit of #5000 or more from a middle stage. Accordingly, the cap substrate 24a can be separated into a plurality of caps 24b. Further, the ventilation path 36 can be formed simultaneously in each of the separated caps 24b. The cavity space 43 formed in the cap 24b is connected to the outside through the ventilation path 36.

Thinning can be performed by applying grinding and chemical mechanical polishing (CMP) as a thinning method for the cap substrate 24a. This method is excellent in productivity since a variation in thickness is less likely to occur and a piezoresistive semiconductor element having a uniform thickness can be ground at a wafer level. When a coarse grinding wheel, for example, a #2000 grinding wheel is applied for grinding until the end, chipping or the like occurs at a corner portion, and thus it is required to finish, using a fine grinding wheel with a grit of #5000 or more, a front surface of the cap 24b after grinding. A thickness of the cap 24b is processed to about 200 µm.

Next, in step (f), after the lower surface side of the piezoresistive semiconductor wafer 40 is fixed with a dicing tape 42, a partial-depth dicing trench 39a (half-dicing trench) is formed in the piezoresistive semiconductor wafer 40 by dicing. Accordingly, dicing trenches 39a are formed vertically and horizontally in the piezoresistive semiconductor wafer 40.

Finally, in step (g), the back-grinding tape 41 is attached to an upper surface side of the cap 24b, and the lower surface side of the piezoresistive semiconductor wafer 40 is ground. A grinding method is the same as the above-described method. Accordingly, separation from a wafer state to the piezoresistive semiconductor chip 3 with the cap 24b is enabled. Thereafter, the piezoresistive semiconductor chip 3 is picked up to complete the pressure sensor of the capped piezoresistive semiconductor chip.

A thickness of the piezoresistive semiconductor chip 3 is preferably, for example, 80 µm or less, and particularly preferably about 50 µm. As a silicon thickness decreases, a deformation region in response to a minute pressure fluctuation can be expanded, and detection accuracy can be improved.

Each electrode 46 is formed outside the cap 24b, and the ventilation path 36 connected to outside air is also formed in each piezoresistive semiconductor chip 3. A position of the ventilation path 36 formed in the cavity space 43 of the cap 24b can be set at any position in the cavity space 43, and at least one ventilation path 36 can be formed in each cap 24b.

A hole diameter of the ventilation path 36 can be set as desired, and is preferably 100 µm or less, and more preferably 20 µm or less. As the hole diameter decreases, intrusion of foreign matters such as debris can be more effectively prevented. In addition, since the ventilation path 36 is formed by dry etching, a shape of the ventilation path 36 can be set as desired.

When the piezoresistive semiconductor chip 3 is thinned by the thinning processing, it is assumed that electrical leakage occurs depending on a structure of the piezoresistive element or silicon material electrical conductivity, and in the invention, it is possible to cope with this by forming a thin film insulator at a front surface of the thinned piezoresistive semiconductor chip 3.

In this way, by applying the production method by wafer level packaging, a thickness of the entire pressure sensor can be processed to about 300 µm, and a thin piezoresistive semiconductor chip equipped with the cap can be produced with high productivity. It is possible to further perform thinning by changing the thickness of the cap. A chip size of about 2.5 mm square can be obtained.

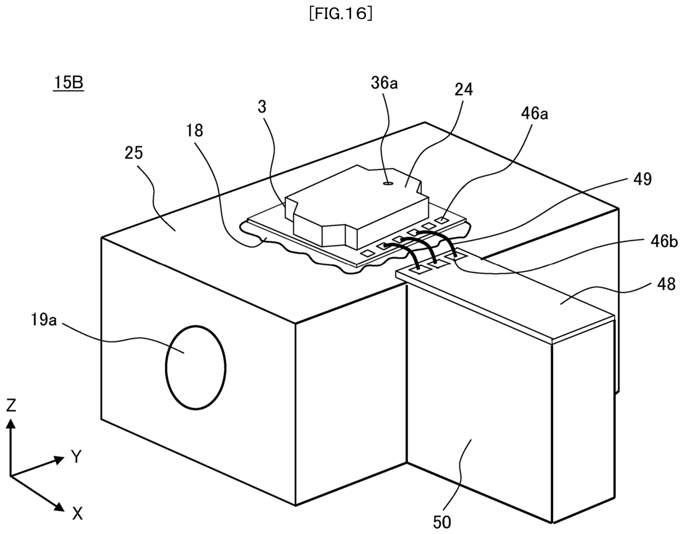

Next, an implementation example of the pressure sensor module of the invention will be described with reference to FIG. 16. FIG. 16 is a perspective view showing an implementation example of a pressure sensor module 15B. FIG. 16 shows an example of electrical wiring to the piezoresistive semiconductor chip 3 mounted on the pressure sensor module 15B.

A long-side direction, a short-side direction, and a height direction of the pressure sensor module 15B are shown as the Y-direction, the X-direction, and the Z-direction, respectively.

The flow path 19 (not shown) is formed inside the flow path substrate 25, screw portions (not shown) are provided at the flow path inlet 19a and the flow path outlet 19b (not shown), and the flow path 19 can be connected to the pipe 8 of the dispensing apparatus 1 shown in FIGS. 6 and 7 via a joint. In addition, the branch path 20 (not shown) branched toward the outside (Z-direction) of the flow path substrate 25 is provided inside the flow path 19, and the thin piezoresistive semiconductor chip 3 closes the terminal end of the branch path 20. The piezoresistive semiconductor chip 3 is bonded (adhered) to the flow path substrate 25 via the adhesive layer 18.

A plurality of electrode pads 46a are disposed at the piezoresistive semiconductor chip 3, and are connected by wires 49 to electrode pads 46b formed at an electrical wiring flexible substrate 48 supported by a frame 50.

Gold wires or aluminum wires may be applied as the wires 49. Alternatively, an anisotropic conductive film (ACF) or the like may be applied for connection. A printed wiring board (PCB) may be applied as the electrical wiring flexible substrate 48.

When the system water flows into the flow path 19 (not shown) in the flow path substrate 25, the system water flows into the branch path 20 (not shown), and a pressure is applied to the piezoresistive semiconductor chip 3. When the pressure is applied, the piezoresistive semiconductor chip 3 deforms, and the deformation is detected as an electric signal and transmitted to the flexible substrate 48 such that the pressure can be measured.

In this way, by applying a structure in which the thin piezoresistive semiconductor chip 3 is directly installed at the terminal end of the branch path 20, since a distance from the flow path 19 to the terminal end of the branch path is short, there is an advantage that a change in the pressure of the system water flowing through the flow path 19 can be accurately detected and a speed of detecting the pressure is increased.

As a strain measurement method, a strain gauge, a piezoelectric element, or the like may be applied instead of the piezoresistive element.

### Second Embodiment

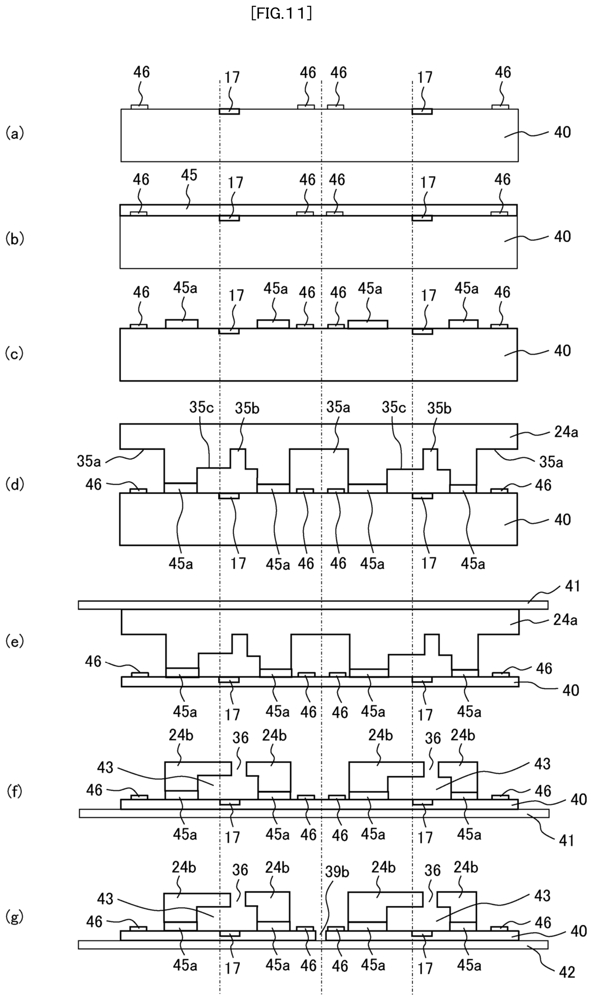

A method for producing a pressure sensor module according to a second embodiment of the invention will be described with reference to FIG. 11.

FIG. 11 is a diagram showing a process flow for producing the pressure sensor by wafer level packaging. FIG. 11 is cross-sectional views showing steps from step (a) to step (g).

In a process of a wafer level packaging method including formation of a ventilation path of a pressure sensor, the capped piezoresistive semiconductor chip can still be obtained by a process different from that in the first embodiment (FIG. 10).

Steps (a) to (d) in FIG. 11 are the same as steps (a) to (d) in FIG. 10, and repeated descriptions will be omitted.

In step (e), the back-grinding tape 41 is attached to the upper surface side of the cap substrate 24a, and the lower surface side of the piezoresistive semiconductor wafer 40 is ground. Accordingly, the thickness of the piezoresistive semiconductor chip 3 can be reduced.

The thickness of the piezoresistive semiconductor chip 3 is preferably, for example, 80 µm or less, and particularly preferably about 50 µm. As a silicon thickness decreases, a deformation region in response to a minute pressure fluctuation can be expanded, and detection accuracy can be improved.

In the grinding, first, rough grinding is implemented by applying a grinding wheel of #2000, and then grinding is performed by applying a fine grinding wheel with a grit of #5000 or more from a middle stage.

Thinning can be performed by applying grinding and chemical mechanical polishing (CMP) as a thinning method for the piezoresistive semiconductor wafer 40. This method is excellent in productivity since a variation in thickness is less likely to occur and a piezoresistive semiconductor element having a uniform thickness can be ground at a wafer level.

When the piezoresistive semiconductor chip 3 is thinned by the thinning processing, it is assumed that electrical leakage occurs depending on a structure of the piezoresistive element or silicon material electrical conductivity, and in the invention, it is possible to cope with this by forming a thin film insulator at the front surface of the thinned piezoresistive semiconductor chip 3.

Next, in step (f), the back-grinding tape 41 is attached to the lower surface side of the thinned piezoresistive semiconductor wafer 40, and the upper surface side of the cap substrate 24a is ground. A grinding method is the same as that described above, and the thickness of the cap 24b is processed to about 200 µm. Accordingly, the cap substrate 24a can be separated into a plurality of caps 24b. Further, the ventilation path 36 can be formed simultaneously in each of the separated caps 24b. The cavity space 43 formed in the cap 24b is connected to the outside through the ventilation path 36.

Finally, in step (g), after the lower surface side of the piezoresistive semiconductor wafer 40 is fixed with the dicing tape 42, a dicing trench 39b (full-cut dicing trench) is formed in the piezoresistive semiconductor wafer 40 by dicing. Dicing trenches 39b are formed vertically and horizontally in the piezoresistive semiconductor wafer 40. Accordingly, separation from a wafer state to the piezoresistive semiconductor chip 3 with the cap 24b is enabled. Thereafter, the piezoresistive semiconductor chip 3 is picked up to complete the pressure sensor of the capped piezoresistive semiconductor chip.

Each electrode 46 is formed outside the cap 24b, and the ventilation path 36 connected to outside air is also formed in each piezoresistive semiconductor chip 3. The position of the ventilation path 36 formed in the cavity space 43 of the cap 24b can be set at any position in the cavity space 43, and at least one ventilation path 36 can be formed in each cap 24b.

The hole diameter of the ventilation path 36 can be set as desired, and is preferably 100 µm or less, and more preferably 20 µm or less. As the hole diameter decreases, intrusion of foreign matters such as debris can be more effectively prevented. In addition, since the ventilation path 36 is formed by dry etching, the shape of the ventilation path 36 can be set as desired.

In this way, by applying the production method by wafer level packaging different from the first embodiment (FIG. 10), a thickness of the entire pressure sensor can be processed to about 300 µm, and a thin piezoresistive semiconductor chip equipped with the cap can be produced with high productivity. It is possible to further perform thinning by changing the thickness of the cap. A chip size of about 2.5 mm square can be obtained.

### Third Embodiment

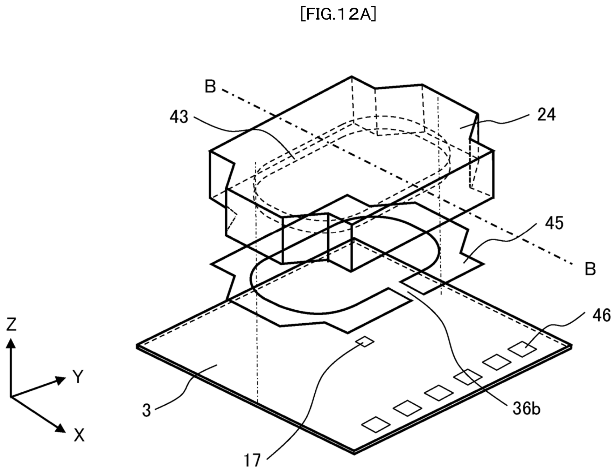

A pressure sensor module according to a third embodiment of the invention and a method for producing the same will be described with reference to FIGS. 12A to 14.

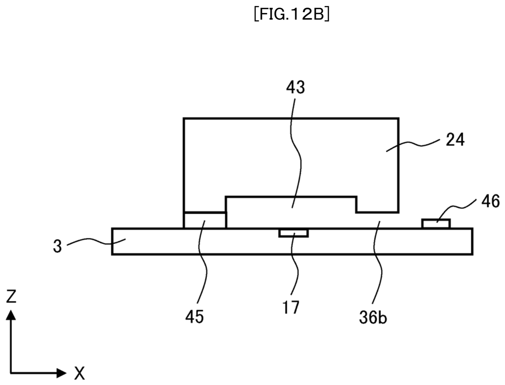

FIG. 12A is a perspective view showing a detailed structure of a pressure sensor of the embodiment, and FIG. 12B is a cross-sectional view taken along line B-B in FIG. 12A. A long-side direction, a short-side direction, and a height direction of the pressure sensor are shown as the Y-direction, the X-direction, and the Z-direction, respectively.

In the piezoresistive semiconductor chip 3, the piezoresistive element 17 is formed at the central portion, the plurality of electrodes 46 are formed at the outer peripheral portion of the chip, and the cap 24 is disposed above. The piezoresistive semiconductor chip 3 and the cap 24 are bonded by the bonding layer 45. Any pattern can be formed using a photosensitive resin material that can be patterned as the material of the bonding layer 45. Therefore, a ventilation path 36b connecting the cavity space 43 and the outside can be formed inside the bonding layer 45 by patterning.

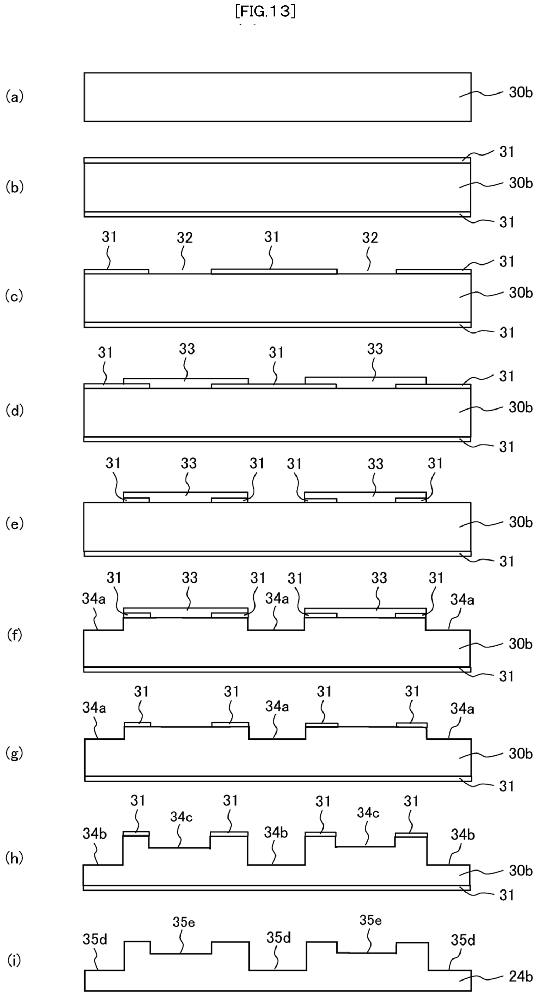

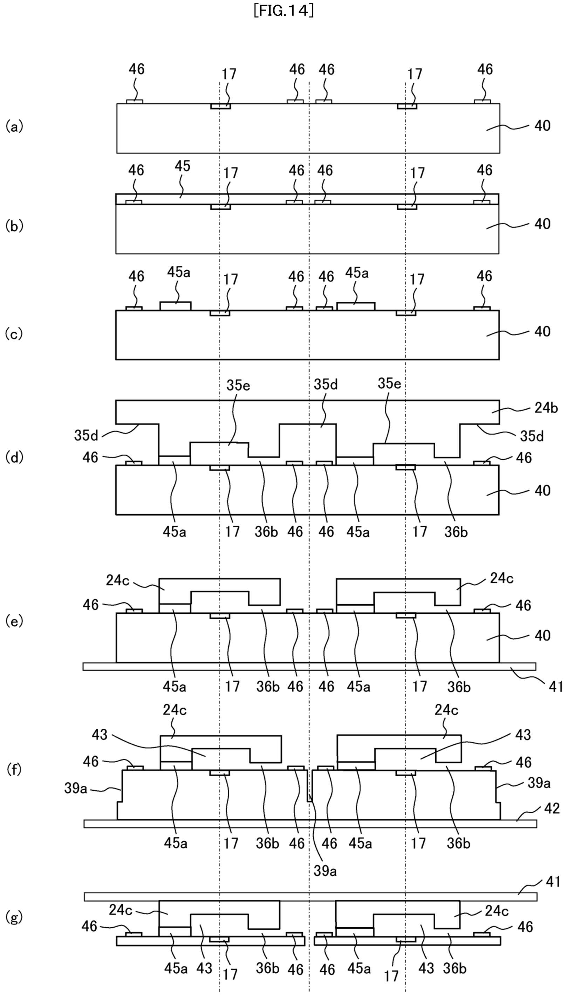

Next, a method for producing the pressure sensor by wafer level packaging including formation of the ventilation path will be described with reference to FIGS. 13 and 14.

FIG. 13 is a diagram showing a process flow for producing the cap substrate 24a for forming the cap 24. FIG. 13 is cross-sectional views showing steps from step (a) to step (i).

First, as shown in step (a), a silicon wafer 30b is prepared.

Next, in step (b), thermal oxide films 31 are formed on front and back surfaces of the silicon wafer 30b. At this time, an alignment mark may be formed in advance on the back surface side of the silicon wafer 30b by photolithography and dry etching.

Next, in step (c), resist pattern formation (resist coating, exposure, and development) by photolithography, etching of the thermal oxide films 31, and resist removal are performed on the front surface of the silicon wafer 30b to form the openings 32 in the thermal oxide film 31.

Next, in step (d), the resist pattern 33 is formed by photolithography to fill the openings 32 and partially overlap the thermal oxide film 31.

Thereafter, in step (e), the thermal oxide film 31 is patterned by etching using the resist pattern 33 as a mask. Accordingly, a multilayer mask is completed.

Next, in step (f), silicon dry etching is applied to form the first etching trenches 34a. By applying the silicon dry etching, it is possible to form a trench having not only a linear planar shape but also a curved planar shape.

The etching trench 34a is processed to a depth of, for example, about 280 µm.

Next, in step (g), the resist pattern 33 is removed. By removing the resist pattern 33, a new silicon front surface is exposed.

Next, in step (h), silicon dry etching is performed using the thermal oxide film 31 as a mask material. Accordingly, the second etching trench 34b and an etching trench 34c having a depth different from that of the etching trench 34b are formed in the silicon wafer 30b, and multi-level trenches having different depths can be formed.

Finally, in step (i), the thermal oxide films 31 are removed to complete a cap substrate 24b having different steps (etching trenches 35d and 35e). The cap substrate 24b can be formed of a 6-inch or 8-inch silicon wafer 30b. In addition, by combining a plurality of mask materials, it is possible to further form trenches with a plurality of different steps.

A detailed production method for the pressure sensor will be described with reference to FIG. 14. FIG. 14 is a diagram showing a process flow for producing the pressure sensor by wafer level packaging. FIG. 14 is cross-sectional views showing steps from step (a) to step (g).

First, as shown in step (a), the piezoresistive semiconductor wafer 40 is prepared. A plurality of piezoresistive elements 17 and a plurality of electrodes 46 are formed at the piezoresistive semiconductor wafer 40.

Next, in step (b), a resin material to be the bonding layer 45 is formed on a surface where the piezoresistive elements 17 and the electrodes 46 are formed. As the resin material 45, a photosensitive resin material is preferably used, and for example, a photosensitive film resist can be applied. If a photosensitive resin material is used, the resin can be planarized and patterned by spin coating.

Next, in step (c), the desired resin material pattern 45a is formed on the piezoresistive semiconductor wafer 40 by photolithography. At this time, an opening is formed in a part of the resin material pattern 45a. By forming the opening by patterning, the ventilation path 36b can be formed in a subsequent separation process. Since the ventilation path can be formed by patterning in this way, one or more ventilation paths 36b can be formed for one cap.

Thereafter, in step (d), the cap substrate 24b is aligned with high accuracy and stacked on the piezoresistive semiconductor wafer 40 by the method shown in FIGS. 9A and 9B. The steps 35 (etching trenches 35e and 35d) of the cap substrate 24b correspond to the etching trenches 35e and 35d in FIG. 13.

By applying pressure and temperature during bonding, the piezoresistive semiconductor wafer 40 and the cap substrate 24b are brought into close contact with each other using the resin material pattern 45a as the bonding layer. Bonding conditions are an applied pressure of 1 MPa and an applied temperature of 300 °C. At this time, the resin material shrinks due to the application of pressure and temperature. Therefore, the resin material before bonding is formed with a thickness in consideration of the shrinkage such that a thickness of the bonding layer after bonding is 50 µm or less, particularly about 20 µm.

Next, in step (e), the back-grinding tape 41 is attached to the lower surface side of the piezoresistive semiconductor wafer 40, and an upper surface side of the cap substrate 24b is ground. A thickness of the cap is processed to about 200 µm. In the grinding, first, rough grinding is implemented by applying a grinding wheel of #2000, and then grinding is performed by applying a fine grinding wheel with a grit of #5000 or more from a middle stage. Accordingly, the cap substrate 24b can be separated into a plurality of caps 24c. Further, the ventilation path 36b can be formed simultaneously in each of the separated caps 24c.

Thinning can be performed by applying grinding and chemical mechanical polishing (CMP) as a thinning method for the cap substrate 24b. This method is excellent in productivity since a variation in thickness is less likely to occur and a piezoresistive semiconductor element having a uniform thickness can be ground at a wafer level. When a coarse grinding wheel, for example, a #2000 grinding wheel is applied for grinding until the end, chipping or the like occurs at a corner portion, and thus it is required to finish, using a fine grinding wheel with a grit of #5000 or more, a front surface of the cap 24c after grinding. At this time, the cavity space 43 formed in the cap 24c is connected to the outside through the ventilation path 36b.

Next, in step (f), after the lower surface side of the piezoresistive semiconductor wafer 40 is fixed with the dicing tape 42, the partial-depth dicing trench 39a (half-dicing trench) is formed in the piezoresistive semiconductor wafer 40 by dicing. Accordingly, dicing trenches 39a are formed vertically and horizontally in the piezoresistive semiconductor wafer 40.

Finally, in step (g), the back-grinding tape 41 is attached to an upper surface side of the cap 24c, and the lower surface side of the piezoresistive semiconductor wafer 40 is ground. A grinding method is the same as the above-described method. Accordingly, separation from a wafer state to the piezoresistive semiconductor chip 3 with the cap 24c is enabled. Thereafter, the piezoresistive semiconductor chip 3 is picked up to complete the pressure sensor of the capped piezoresistive semiconductor chip.

The thickness of the piezoresistive semiconductor chip 3 is preferably, for example, 80 µm or less, and particularly preferably about 50 µm. As a silicon thickness decreases, a deformation region in response to a minute pressure fluctuation can be expanded, and detection accuracy can be improved.

When the piezoresistive semiconductor chip 3 is thinned by the thinning processing, it is assumed that electrical leakage occurs depending on a structure of the piezoresistive element or silicon material electrical conductivity, and in the invention, it is possible to cope with this by forming a thin film insulator at the front surface of the thinned piezoresistive semiconductor chip 3.

Each electrode 46 is formed outside the cap 24c, and the ventilation path 36b connected to outside air is also formed in each piezoresistive semiconductor chip 3.

Since the ventilation path 36b can be formed by patterning the resin material that is the bonding layer, the ventilation path 36b can be freely disposed. A width of the ventilation path 36b can also be set as desired, and is preferably widened by about several microns depending on the pressure and temperature at the time of bonding, thus the width is preferably 30 µm or less, and intrusion of foreign matters such as debris can be more effectively prevented as the width decreases. In addition, as a shape of the ventilation path 36b, a structure with a bent line, a structure formed with a curve, or the like can be applied.

In this way, using a method different from those of the first embodiment and the second embodiment, that is, by providing the ventilation path at a bonding portion, the thickness of the entire pressure sensor can be processed to about 300 µm without increasing the number of processes, and the thin piezoresistive semiconductor chip equipped with the cap can be produced with high productivity. It is possible to further perform thinning by changing the thickness of the cap. A chip size of about 2.2 mm square can be obtained.

### Fourth Embodiment

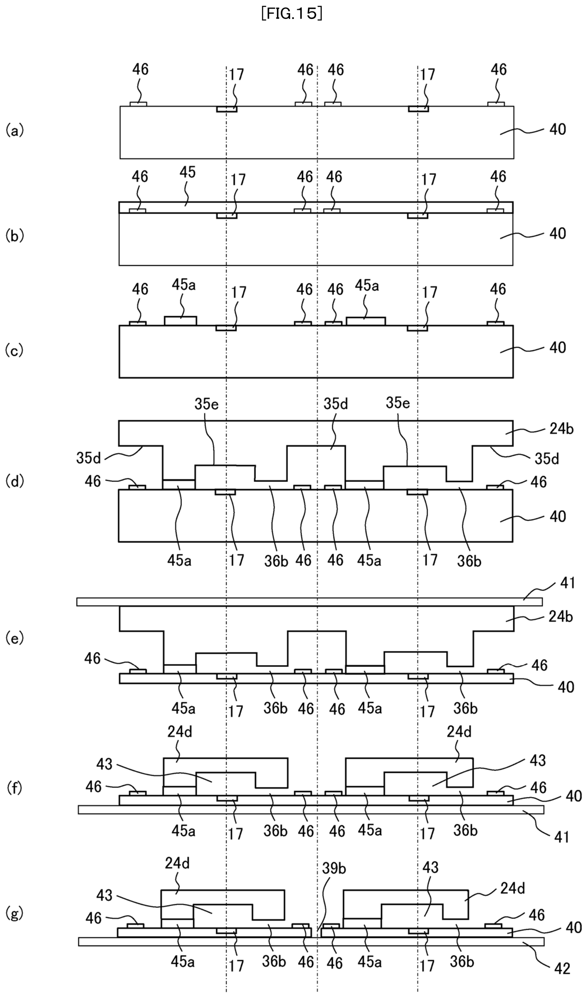

A method for producing a pressure sensor module according to a fourth embodiment of the invention will be described with reference to FIG. 15.

FIG. 15 is a diagram showing a process flow for producing the pressure sensor by wafer level packaging. FIG. 15 is cross-sectional views showing steps from step (a) to step (g).

In a process of a wafer level packaging method including formation of a ventilation path of a pressure sensor, the capped piezoresistive semiconductor chip can still be obtained by a process different from that in the third embodiment (FIG. 14).

Steps (a) to (d) in FIG. 15 are the same as steps (a) to (d) in FIG. 14, and repeated descriptions will be omitted.

In step (e), the back-grinding tape 41 is attached to the upper surface side of the cap substrate 24b, and the lower surface side of the piezoresistive semiconductor wafer 40 is ground. Accordingly, the thickness of the piezoresistive semiconductor chip 3 can be reduced.

The thickness of the piezoresistive semiconductor chip 3 is preferably, for example, 100 µm or less, and particularly preferably about 50 µm. As a silicon thickness decreases, a deformation region in response to a minute pressure fluctuation can be expanded, and detection accuracy can be improved.

In the grinding, first, rough grinding is implemented by applying a grinding wheel of #2000, and then grinding is performed by applying a fine grinding wheel with a grit of #5000 or more from a middle stage.

Thinning can be performed by applying grinding and chemical mechanical polishing (CMP) as a thinning method for the piezoresistive semiconductor wafer 40. This method is excellent in productivity since a variation in thickness is less likely to occur and a piezoresistive semiconductor element having a uniform thickness can be ground at a wafer level.

When the piezoresistive semiconductor chip 3 is thinned by the thinning processing, it is assumed that electrical leakage occurs depending on a structure of the piezoresistive element or silicon material electrical conductivity, and in the invention, it is possible to cope with this by forming a thin film insulator at the front surface of the thinned piezoresistive semiconductor chip 3.

Next, in step (f), the back-grinding tape 41 is attached to the lower surface side of the thinned piezoresistive semiconductor wafer 40, and the upper surface side of the cap substrate 24b is ground. A grinding method is the same as that described above, and the thickness of the cap 24b is processed to about 180 µm. Accordingly, the cap substrate 24b can be separated into a plurality of caps 24d. Further, the ventilation path 36b can be formed simultaneously in each of the separated caps 24d. The cavity space 43 formed in the cap 24d is connected to the outside through the ventilation path 36b.

Finally, in step (g), after the lower surface side of the piezoresistive semiconductor wafer 40 is fixed with the dicing tape 42, the dicing trench 39b (full-cut dicing trench) is formed in the piezoresistive semiconductor wafer 40 by dicing. Dicing trenches 39b are formed vertically and horizontally in the piezoresistive semiconductor wafer 40. Accordingly, separation from a wafer state to the piezoresistive semiconductor chip 3 with the cap 24d is enabled. Thereafter, the piezoresistive semiconductor chip 3 is picked up to complete the pressure sensor of the capped piezoresistive semiconductor chip.

Each electrode 46 is formed outside the cap 24d, and the ventilation path 36b connected to outside air is also formed in each piezoresistive semiconductor chip 3.

Since the ventilation path 36b can be formed by patterning the resin material that is the bonding layer, the ventilation path 36b can be freely disposed. The width of the ventilation path 36b can also be set as desired, and is preferably widened by about several microns depending on the pressure and temperature at the time of bonding, thus the width is preferably 30 µm or less, and intrusion of foreign matters such as debris can be more effectively prevented as the width decreases. In addition, as the shape of the ventilation path 36b, a structure with a bent line, a structure formed with a curve, or the like can be applied.

### Fifth Embodiment

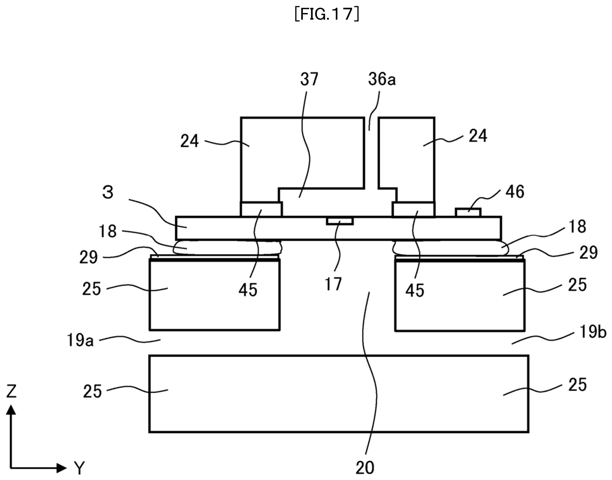

A pressure sensor module according to a fifth embodiment of the invention will be described with reference to FIG. 17.

FIG. 17 is a cross-sectional view showing a structure of the pressure sensor module of the embodiment.

In the first embodiment to the fourth embodiment, the structures related to the pressure sensor structure of the invention and the processes for producing the same have been described, and alternatively, a method of forming a thin film 29 made of the same material as the piezoresistive semiconductor chip 3 around an outlet of the branch path 20 of the flow path substrate 25 can be applied as a method for improving bonding strength of the pressure sensor disposed at the flow path substrate 25.

For example, when the thin film 29 is not formed, a bonding interface formed of two materials, that is, stainless steel which is a material of the flow path substrate 25 and silicon which is a material of the piezoresistive semiconductor chip 3 is formed by the adhesive layer 18.

By forming the thin film 29 on the stainless steel, an interface of the adhesive layer 18 only needs to consider adhesion to the same silicon, and an adhesive material applied to the adhesive layer 18 is also easily selected.

If a thickness of the thin film 29 formed around the outlet of the branch path 20 of the flow path substrate 25 is a thickness of 100 nm to 300 nm, bonding strength can be improved. It is also possible to form the thin film thicker than this, but if the thin film is formed too thick, there is a possibility that delamination from the stainless steel occurs due to stress in the thin film.

In the invention, the position and the formation method of the ventilation path can be selected, two methods can be selected for the production process, and thus a range of the production method can be widened to allow flexible selection.

The invention is not limited to the embodiments described above, and includes various modifications. For example, the embodiments described above have been described in detail to facilitate understanding of the invention, and the invention is not necessarily limited to those including all the configurations described above. A part of a configuration of a certain embodiment can be replaced with a configuration of another embodiment, and a configuration of another embodiment can be added to a configuration of a certain embodiment. Another configuration may be added to a part of a configuration of each embodiment, or a part of a configuration of each embodiment may be deleted or replaced with another configuration.

### Reference Signs List

- 1: dispensing apparatus
- 2: nozzle
- 3: piezoresistive semiconductor chip
- 4: syringe pump
- 5: electromagnetic valve
- 6: gear pump
- 7: tank
- 8: pipe
- 9: container
- 10: plunger
- 11: ball screw
- 12: drive motor
- 13: sample dispensing mechanism
- 14: control board
- 15A, 15B: pressure sensor module
- 16: dispensing arm
- 17: piezoresistive element
- 18: adhesive layer
- 19: flow path
- 19a: flow path inlet
- 19b: flow path outlet
- 20, 20a: branch path
- 21: system water
- 22: liquid
- 23: segmenting air
- 24: cap
- 24a, 24b, 24c, 24d: cap substrate
- 25: flow path substrate
- 29: thin film
- 30a, 30b: silicon wafer
- 31: thermal oxide film
- 32: opening
- 33: resist pattern
- 34a, 34b, 34c, 35a, 35b, 35c, 35d, 35e: etching trench
- 35: step
- 36, 36a, 36b: ventilation path
- 37, 37a, 37b, 37c, 43: cavity space
- 39a, 39b: dicing trench
- 40: piezoresistive semiconductor wafer
- 41: back-grinding tape
- 42: dicing tape
- 44: water pressure
- 45: bonding layer (resin material)
- 45a: resin material pattern
- 46: electrode
- 46a, 46b: electrode pad
- 47a, 47b: alignment mark
- 48: flexible substrate
- 49: wire
- 50: frame
- 51: deformation region

## Claims

1. A pressure sensor module comprising:
a flow path substrate including therein a flow path and a branch path branched from the flow path;
a semiconductor chip including a piezoresistive element and covering an opening of the branch path; and
a cap bonded onto the semiconductor chip to cover the piezoresistive element and forming a cavity between the cap and the semiconductor chip, wherein
a ventilation path that allows the cavity to communicate with outside is formed in the cap or a bonding portion between the cap and the semiconductor chip, and
a shape of the opening of the branch path and a shape of the cavity are substantially similar in a normal direction.

2. The pressure sensor module according to claim 1, wherein
the shape of the opening of the branch path and the shape of the cavity are substantially similar in a plan view of the pressure sensor module.

3. The pressure sensor module according to claim 1, wherein
the shape of the cavity has different lengths in a long-side direction and a short-side direction of the pressure sensor module, and the lengths are symmetrical lengths with respect to a center point of the cavity.

4. The pressure sensor module according to claim 1, wherein
the ventilation path is formed in the normal direction in the cavity of the cap.

5. The pressure sensor module according to claim 1, wherein
the cap and the semiconductor chip are bonded via a resin material, and
the ventilation path is formed in the resin material.

6. The pressure sensor module according to claim 1, wherein
the semiconductor chip is bonded to the flow path substrate via an adhesive layer, and
a film of a same material as the semiconductor chip is formed at a bonding surface of the flow path substrate with the semiconductor chip.

7. A pressure sensor module production method for producing the pressure sensor module according to any one of claims 1 to 6, the method comprising:
(a) a step of preparing a first substrate where a plurality of piezoresistive elements are formed;
(b) a step of forming a plurality of trenches having different depths in a second substrate by dry etching using a multilayer mask method;
(c) a step of forming a resin material on a front surface of the first substrate and patterning;
(d) a step of positioning using an alignment mark of the first substrate and an alignment mark of the second substrate, and bonding the first substrate and the second substrate by heating and pressurization; and
(e) a step of thinning the first substrate and the second substrate by grinding surfaces of the first substrate and the second substrate, which are integrated in the step (d), opposite to bonding surfaces of the first substrate and the second substrate, and a step of dicing the first substrate to singulate the first substrate and the second substrate which are integrated.
Module Structure

8. The pressure sensor module production method according to claim 7, wherein
the surfaces of the first substrate and the second substrate, which are integrated, opposite to the bonding surfaces are ground with a grinding wheel finer than #5000, and a thickness of the first substrate and the second substrate which are integrated is reduced to 300 µm or less.
